# EUROPÄISCHE PATENTANMELDUNG

(11) **EP 4 659 994 A1**
(43) Veröffentlichungstag der Anmeldung: **10.12.2025**
(21) Anmeldenummer: 25315198.9
(22) Anmeldetag: 05.06.2025
(51) Int. Cl.: B60L 53/16, B60L 53/302, H01M 10/655, H01M 10/6556, H01R 13/00, H02G 5/10

(54) **GEKÜHLTE STROMSCHIENE UND LADESYSTEM**

(30) Priorität: 05.06.2024 DE 102024115734
(71) Anmelder: Nexans, 92400 Courbevoie (FR)
(72) Erfinder: Kroop, Tobias, 92400 COURBEVOIE (FR)
(74) Vertreter: Ipsilon

(57) **Zusammenfassung**

Es wird eine elektrische Stromschiene (100) vorgeschlagen, die als Hohlprofil (101) ausgebildet ist, dessen Hohlraum (104) von einem Kühlmittel durchströmt ist. Die Stromschiene weist einen Einlassanschluss und einen Auslassanschluss auf, wobei der Einlassanschluss so ausgebildet ist, um das Einströmen eines Kühlmittels in den Hohlraum zu gestatten. Der Auslassanschluss ist so ausgebildet, um das Ausströmen des Kühlmittels aus dem Hohlraum zu ermöglichen. Mit den Enden (106) der Stromschiene bzw. des Hohlprofils sind Kontaktstücke (107) stoffschlüssig und elektrisch leitend verbunden sind und verschließen den Hohlraum dicht. Weiterhin wird ein Ladesystem mit einer solchen Stromschiene vorgeschlagen.

## Beschreibung

### Gebiet

Die Erfindung betrifft eine gekühlte Stromschiene und ein Ladesystem mit einer solchen Stromschiene, insbesondere für Batterie elektrische Fahrzeuge.

### Hintergrund

Die Verbreitung von Elektrofahrzeugen nimmt beständig zu, was politisch und gesellschaftlich gewünscht ist, um die Abgasbelastung insbesondere in Ballungszentren zu reduzieren dabei gleichzeitig den CO2 Ausstoß durch den Verkehr in dem Maße abzusenken, wie so genannter grüner Strom für den Betrieb von Fahrzeugen zur Verfügung steht. Ein Hemmschuh für die weitere Verbreitung von Elektrofahrzeugen ist neben der begrenzten elektrischen Reichweite die Zeitdauer, die zum Aufladen des Batteriespeichers (kurz: Batterie) eines Fahrzeuges benötigt wird. Die Aufladung einer Batterie eines Elektrofahrzeuges benötigt immer noch erheblich mehr Zeit als das Auftanken eines herkömmlichen Fahrzeuges mit Verbrennungsmotor, was typischerweise in wenigen Minuten erledigt werden kann. Daher besteht der Wunsch, die erforderliche Ladezeit durch eine Erhöhung der elektrischen Ladeleistung zu verkürzen. Derzeit liegen die Ladespannungen bei bis zu 500 V, um eine Ladeleistung von 50 kW zu erreichen. Bei so hohen Ladeströmen entwickelt sich naturgemäß ohmsche Wärme auch in den Leitern, die die Ladedose des Elektrofahrzeuges mit seinem Batteriespeicher verbinden. Dennoch dürfen bei einem schnellen Ladevorgang, der zum Beispiel 15 Minuten lang dauert, Grenztemperaturen insbesondere an den Anschlusskontakten der Ladedose bzw. des Batteriespeichers nicht überschritten werden. Eine Möglichkeit dieses Ziel zu erreichen ist, den Leitungsquerschnitt der Verbindungsleitung, die die Ladedose mit dem Batteriespeicher verbindet und die häufig als Stromschiene ausgelegt ist, so zu vergrößern, dass die zulässigen Grenztemperaturen an den kritischen Stellen nicht erreicht werden. Nachteilig bei diesem Ansatz ist, dass hierfür ein hoher Materialeinsatz notwendig ist und gleichzeitig das Fahrzeuggewicht zunimmt, was generell unerwünscht ist. Eine alternative Möglichkeit besteht darin, die Stromschienen, die den Ladestrom transportieren, zu kühlen, um zu verhindern das Grenztemperaturen erreicht bzw. überschritten werden.

Hiervon ausgehend hat die vorliegende Erfindung die Aufgabe, eine Stromschiene und ein Ladesystem mit einer solchen Stromschiene zu schaffen, um eines oder mehrere der eingangs genannten Probleme zu überwinden oder zumindest zu verbessern.

### Beschreibung der Erfindung

Zur Lösung dieser Aufgabe schlägt die Erfindung nach einem ersten Aspekt eine elektrische Stromschiene vor, die als Hohlprofil ausgebildet ist, dessen Hohlraum von einem Kühlmittel durchströmt ist. Die Stromschiene weist einen Einlassanschluss und einen Auslassanschluss auf, wobei der Einlassanschluss so ausgebildet ist, um das Einströmen eines Kühlmittels in den Hohlraum zu gestatten. Der Auslassanschluss ist so ausgebildet, um das Ausströmen des Kühlmittels aus dem Hohlraum zu ermöglichen. Mit den Enden der Stromschiene bzw. des Hohlprofils sind Kontaktstücke stoffschlüssig und elektrisch leitend verbunden sind und verschließen den Hohlraum dicht.

Die Stromschiene ist vor allem für den Einbau in Elektrofahrzeugen zur Verbindung einer Ladedose mit einem elektrischen Batteriespeicher geeignet. Mit dem Kühlmittel, das die Stromschiene durchströmt, wird insbesondere bei einem Schnellladevorgang der Temperaturanstieg vor allem an den Kontaktstücken auf Werte begrenzt, die für Kontaktstellen noch zulässig sind, zum Beispiel auf 90°C. Das Kühlmittel kühlt mittels der stoffschlüssigen Verbindung zwischen der Stromschiene und dem Kontaktstück auch das Kontaktstück. Gleichzeitig bewirken die Kontaktstücke eine Abdichtung des Hohlraums der Stromschiene und verhindern das Ausströmen des Kühlmittels. Das Kühlmittel bewegt sich somit in einem geschlossenen Kühlkreislauf durch die Stromschiene.

Bei einer Weiterbildung der Stromschiene ist der Hohlraum durch Trennwände in eine Mehrzahl von Einzelhohlräumen aufgeteilt ist.

Bei diesem Ausführungsbeispiel wird die Kontaktfläche zwischen Kühlmittel und dem stromtragenden Metall mittels der Trennwände vergrößert. Auf diese Weise wird die Kühlwirkung des Kühlmittels auf die Stromschiene gesteigert.

Mit Vorteil strömt das Kühlmittel in einem ersten Einzelhohlraum in einer ersten Strömungsrichtung. In einem zweiten Einzelhohlraum strömt das Kühlmittel in einer zweiten Strömungsrichtung, die der ersten Strömungsrichtung entgegengesetzt ist.

Mit dieser Ausführungsform der Stromschiene kann eine gleichmäßige Temperaturverteilung in Ladesystemen erreicht werden, die zwei Stromschienen aufweisen.

Gemäß einem zweiten Aspekt betrifft die Erfindung ein Ladesystem für einen batterieelektrischen Stromspeicher. Das Ladesystem weist einen mit einer Stromquelle verbindbaren Anschluss, eine Stromsenke, eine Stromschiene gemäß dem ersten Aspekt der Erfindung, die die Stromquelle mit der Stromsenke elektrisch verbindet, sowie eine Wärmesenke auf, die von dem Kühlmittel durchströmt ist.

Bei einem Ausführungsbeispiel ist die Stromquelle eine Ladesäule und die Stromsenke ein Batteriespeicher. Die Ladesäule wird mit einem Ladekabel mit dem verwendbaren Anschluss verbunden und liefert den Ladestrom zum Aufladen des Batteriespeichers.

Mit Vorteil umfasst das Ladesystem zwei Stromschienen, die an jeweils einem Ende strömungsmäßig und elektrisch voneinander isoliert miteinander verbunden sind, sodass das Kühlmittel aus der einen Stromschiene ausströmt und in die andere Stromschiene einströmt. Die anderen Enden der beiden Stromschienen einen Einlassanschluss bzw. einen Auslassanschluss aufweisen, die strömungsmäßig mit der Wärmesenke verbunden sind.

Die Wärmesenke kann jede Anordnung sein, die geeignet ist, um Wärme von dem Kühlmittel aufzunehmen, dass durch die Stromschienen fließt.

Bei einem Ausführungsbeispiel ist die Wärmesenke ein Wärmetauscher, ein Batteriespeicher, eine elektrische Maschine und/oder eine Vorrichtung zur Regelung der Temperatur eines Innenraums.

Bei einer Ausführungsform ist der Wärmetauscher luftgekühlt.

Vorteilhafterweise kann das Ladesystem zwei Stromschienen umfassen, die jeweils zwei oder mehr Einzelhohlräume aufweisen, in denen das Kühlmittel in entgegengesetzten Richtungen strömt.

Durch diese Ausbildung des Ladesystems strömt in jeder der beiden Stromschienen sowohl Kühlmittel, das in der Wärmesenke abgekühlt ist als auch Kühlmittel dass die jeweils andere Stromschiene bereits durchflossen hat und gegenüber dem von der Wärmesenke kommenden Kühlmittel eine höhere Temperatur aufweist. Auf diese Weise wird erreicht das die beiden Stromschienen annähernd die gleiche Temperatur aufweisen. Im Unterschied dazu kann es bei einem Ladesystem, bei dem das Kühlmittel zunächst die eine Stromschiene durchströmte und anschließend die andere Stromschiene, bevor es wieder zu der Wärmesenke zurückkehrt, zu Temperatur unterschieden zwischen den Stromschienen kommen, was zur Folge haben kann, dass eine zulässige Grenztemperatur von der wärmeren Stromschiene schneller erreicht wird als bei einem Ladesystem, bei dem die Stromschienen auf einer gleichmäßigen Temperatur sind.

### Kurze Beschreibung der Zeichnung

Nachfolgend wird die Erfindung anhand einer Ausführungsform unter Bezugnahme auf die begleitenden Figuren exemplarisch näher erläutert. Alle Figuren sind rein schematisch und nicht maßstäblich. Es zeigen:
- Fig. 1A: eine erfindungsgemäße Stromschiene;
- Fig. 1B: einen alternativen Schlauchanschluss für ein Kühlmittel für die in Figur 1A gezeigt Stromschiene;
- Fig. 1C: einen zweiten alternativen Schlauchanschluss für ein Kühlmittel für die in Figur 1A gezeigt Stromschiene;
- Fig. 2A-C: Ausführungsbeispiele für ein Ladesystem mit einer erfindungsgemäßen Stromschiene; und
- Fig. 3: eine weitere erfindungsgemäße Stromschiene im Querschnitt.

Gleiche oder ähnliche Elemente sind in den Figuren mit gleichen oder ähnlichen Bezugszeichen versehen.

### Ausführungsbeispiel

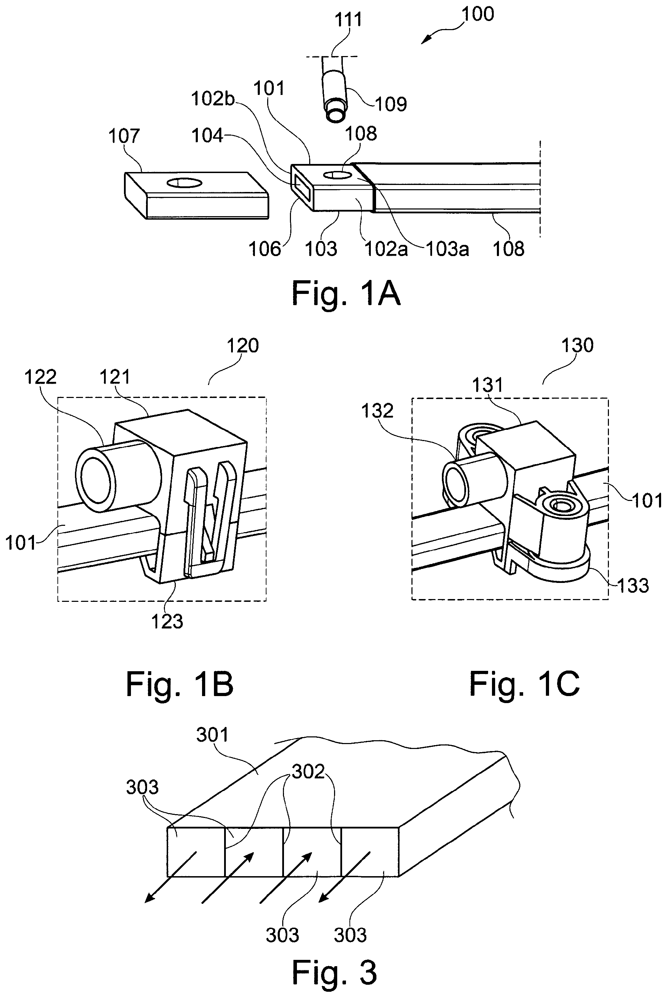

Figur 1A zeigt eine Stromschiene 100 gemäß der vorliegenden Erfindung. Die Stromschiene 100 ist aus einem Rechteckrohr 101 gebildet, dass zwei schmale Seiten 102a,b und zwei breite Seiten 103a,b aufweist. Bei einem Ausführungsbeispiel der Stromschiene 100 ist das Rechteckrohr 101 aus Aluminium oder Kupfer hergestellt. Grundsätzlich kann das Rechteckrohr 101 auch aus anderen elektrisch gut leitenden Materialien bestehen. Es wird angemerkt, dass die vorliegende Erfindung nicht auf Rechteckrohre eingeschränkt ist, sondern auch andere Rohrquerschnitte angewendet werden können, zum Beispiel runde ovale oder vieleckige Rohrquerschnitte. Die weitere Beschreibung ist jedoch auf Rechteckrohre bezogen, weil diese in der Praxis häufig eingesetzt sind. Die schmalen Seiten 102a,b und die breiten Seiten 103a,b bilden eine umlaufende Wand, die einen Hohlraum 104 umschließt. Das Rechteckrohr 101 weist zwei Enden 106 auf, an die jeweils ein Kontaktstück 107 mittels einer stoffschlüssigen Verbindung angebracht ist, so dass eine mechanisch stabile Verbindung zwischen dem Rechteckrohr 101 und den Kontaktstücken 107 entsteht und gleichzeitig der Innenraum 104 an den Enden 106 des Rechteckrohrs 101 dicht verschlossen ist. Die Kontaktstücke 107 sind zum Beispiel angeschweißt oder angelötet. In der breiten Seite 103a ist ein Gewindeloch 108 vorgesehen, in das ein Schlauchnippel 109 einschraubbar ist, um eine strömungsmäßige Verbindung zwischen dem Innenraum 104 und einem Schlauch 111 herzustellen. Das in Figur 1A dargestellte Gewindeloch 108 bildet eine Einlassöffnung. Das in Figur 1A nicht gezeigte Ende des Rechteckrohrs 101 bildet eine entsprechende Auslassöffnung, die mit der Anordnung aus einem weiteren Schlauchnippel und einem Schlauch 111 ebenfalls eine strömungsmäßige Verbindung zu dem Innenraum 104 des Rechteckrohrs 101 herstellt.

Das an seinen Enden 106 mit Kontaktstücken 107 verschlossene und mit einer Einlass- bzw. Auslassöffnung versehene Rechteckrohr 101 bildet eine Stromschiene 100 gemäß der vorliegenden Erfindung. Das Rechteckrohr 101 erfüllt im Betrieb der Stromschiene 100 zwei Funktionen, nämlich die Funktion eines elektrischen Leiters mittels der Wände des Rechteckrohrs 101 und die Funktion eines Fluidleiters für ein Kühlmittel, wobei der von den Wänden des Rechteckrohrs 101 umschlossene Hohlraums 104 den Fluidleiter bildet. Zur elektrischen Isolierung ist das Rechteckrohr 101 mit einem Isoliermantel 108 ummantelt.

Als Kühlmittel ist jedes fließfähige gasförmige oder flüssige Medium geeignet, dass eine geringe elektrische, aber eine hohe thermische Leitfähigkeit aufweist. In der Praxis sind Flüssigkeiten leichter als Gase zu beherrschen, weshalb der Kürze halber die Ausführungsbeispiele mit einer Flüssigkeit als Kühlmittel beschrieben sind, wobei das nicht so zu verstehen, dass die Erfindung auf Flüssigkeiten als Kühlmittel eingeschränkt ist. Ein Beispiel für eine geeignete Kühlflüssigkeit ist von der Firma 3M unter der Marke Novec 7000 kommerziell erhältlich.

Mittels der Schläuche 111 ist es möglich, ein Kühlmittel durch die Stromschiene 100 in einem Kreislauf zu führen und dadurch die Temperatur der Stromschiene zu kontrollieren. Die Kontaktstücke 107 werden durch Wärmeleitung zwischen dem Rechteckrohr 101 und den Kontaktstücken 107 ebenfalls gekühlt. Die Kühlung der Stromschiene 100 wird dadurch bewirkt, dass ein Wärmeübergang von dem Rechteckrohr bzw. den Wänden des Rechteckrohrs zu dem Kühlmittel erfolgt. Das Kühlmittel wiederum wird in einem Kühler gekühlt. Als Kühler funktioniert jede Wärmesenke, die beim Durchströmen des Kühlmittels dessen Temperatur absenkt. Unterschiedliche Ausgestaltungen einer Wärmesenke werden weiter unten beschrieben.

Figur 1B zeigt einen alternativen Schlauchanschluss 120, der aus zwei Teilen aufgebaut ist. Eine Anschlusskomponente 121 weist eine Schlauchtülle 122 auf, die strömungsmäßig mit einem an der Anschlusskomponente 121 angeordneten Stutzen (in Figur 1B nicht dargestellt) verbunden ist und eine strömungsmäßige Verbindung mit dem Hohlraum 104 des Rechteckrohrs 101 herstellt. Die Anschlusskomponente 121 ist mit einer Haltekomponente 123 verrastet, sodass das Rechteckrohr 101 zwischen der Anschlusskomponente 121 und der Haltekomponente 123 hindurchgeführt ist. Die Schlauchtülle 122 ist zur Herstellung eines Kühlkreislauf für das in dem Rechteckrohr 101 strömende Kühlmittel, indem ein Schlauch auf die Schlauchtülle 122 aufgesteckt wird.

Figur 1C zeigt einen weiteren alternativen Schlauchanschluss 130, der aus zwei Teilen aufgebaut ist. Eine Anschlusskomponente 131 weist eine Schlauchtüre 132 auf, die strömungsmäßig mit einem an der Anschlusskomponente angeordneten Stutzen (in Figur 1B nicht dargestellt) verbunden ist und eine strömungsmäßige Verbindung mit dem Hohlraum 104 des Rechteckrohrs 101 herstellt. Die Anschlusskomponente 131 ist mit einer Haltekomponente 133 in der Weise verschraubt, dass das Rechteckrohr 101 zwischen der Anschlusskomponente 131 und der Haltekomponente 133 hindurchgeführt und eingeklemmt ist. Die Schlauchtülle 132 ist zur Herstellung eines Kühlkreislaufs für das in dem Rechteckrohr 101 strömenden Kühlmittel mit einem Schlauch verwendbar. Zu diesem Zweck wird ein Schlauch auf die Schlauchtülle 132 aufgesteckt.

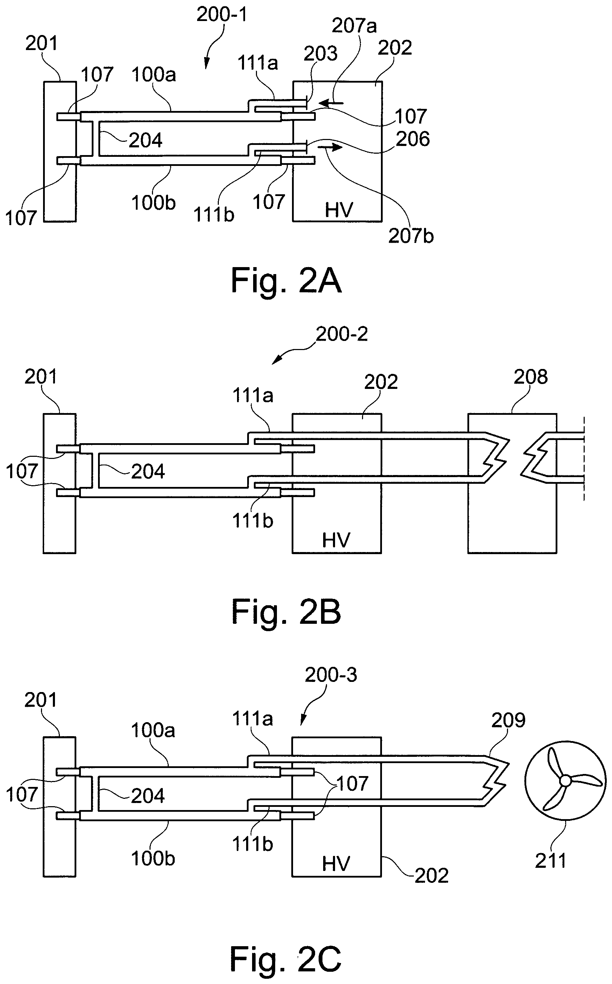

Figur 2A zeigt schematisch einen Ausschnitt aus einem Ladesystem 200-1 für ein Elektrofahrzeug, insbesondere ein batterieelektrisches Elektrofahrzeug, bei dem bei einem Schnellladevorgang sehr hohe Ladeströme fließen, die zu einer entsprechend großen Erwärmung in den stromführenden Leitungen führen. Ein Elektrofahrzeug ist ein Beispiel für einen Anwendungsfall der Erfindung. Grundsätzlich ist die Erfindung für alle Anwendungsfälle geeignet, wo hohe Ströme fließen, die zu einer Erwärmung der stromführenden Leiter bzw. Kontakte führen, die zulässige Grenztemperaturen nicht übersteigen dürfen und daher eine entsprechende Kühlung von stromführenden Leitungen und Kontakten erforderlich machen.

Das Ladesystem 200-1 umfasst eine Ladedose 201, die an eine Außenseite einer Karosserie des Elektrofahrzeuges zugänglich angeordnet ist. In die Ladedose wird bei einem Ladevorgang ein Ladekabel eingesteckt, das die Ladedose mit einer Ladesäule verbindet, die den Strom liefert, um eine Batterie des Elektrofahrzeuges aufzuladen. Die Ladedose 201 ist mit zwei Stromschienen 100a,b mit einer Hochvoltbatterie 202 verbunden. Zu diesem Zweck sind die Stromschienen 100a,b mit Kontaktstücken 107 mit entsprechenden Anschlusskontakten an der Ladedose 201 und der Hochvoltbatterie 202 verbunden, beispielsweise angeschraubt.

Ein Schlauch 111a der Stromschiene 100a ist an einen Kühlmittelauslass 203 der Hochvoltbatterie 202 angeschlossen, die mit einem Kühlmittelkreislauf ausgerüstet ist und einen eigenen Kühlmittelkühler (nicht dargestellt) aufweist. Das Kühlmittel strömt in der Stromschiene 100a zu einem an dem gegenüberliegenden Ende der Stromschiene 100a angeordneten Verbindungsstück 204, das eine Kühlmittelauslassöffnung der Stromschiene 100a mit einer Kühlmitteleinlassöffnung 206 der Stromschiene 100b verbindet. Das Kühlmittel durchströmt die Stromschiene 100b hin zu einem Schlauch 111b, der an einen Kühlmitteleinlass 206 der Hochvoltbatterie 202 angeschlossen ist. Die Strömungsrichtung des Kühlmittels ist durch Pfeile 207a 207b angedeutet. Das von dem Kühlkreislauf der Hochvoltbatterie 202 heruntergekühlte Kühlmittel sorgt für eine Kühlung der Stromschienen 100a,b während eines Schnellladevorgangs, der zeitlich begrenzt ist bzw. abgebrochen wird, wenn eine Grenztemperatur an einer kritischen Komponente des Ladesystems überschritten ist.

Figur 2B ist eine weitere schematische Darstellung für ein Ladesystem 200-2. Im Unterschied zu dem Ladesystem 200-1 sind die Schläuche 111 nicht an einen Kühlkreislauf der Hochvoltbatterie 202 angeschlossen, sondern an einen Wärmetauscher 208, der das in den Stromschienen 100a,b fließende Kühlmittel kühlt und auf diese Weise Wärme von den Stromschienen 100a,b abführt. Bei dem Wärmetauscher 208 kann es sich um einen dezidierten Wärmetauscher handeln, der ausschließlich für die Kühlung des Kühlmittels vorgesehen ist, das in den Stromschiene 100a,b fließt. Der Wärmetauscher 208 kann aber auch mehrere Medienkreisläufe aufweisen und beispielsweise unter anderem für die Temperaturregelung eines Fahrzeuginnenraum, der Hochvoltbatterie und/oder eines Antriebsmotors verwendet werden.

Figur 2C zeigt schematisch ein weiteres Ladesystem 200-3, bei dem das in den Stromschienen 100a,b fließende Kühlmittel durch eine Kühlschlange 209 fließt und mit einem Luftstrom gekühlt wird der von einem Ventilator 211 erzeugt wird.

Bei allen Ladesystemen 200-1, 200-2 und 200-3 ist die Kühlung der Stromschienen 100a,b ist so dimensioniert, dass ein Schnellladevorgang ohne Unterbrechung durchführbar ist.

Figur 3 zeigt eine perspektivische Ansicht eines Rechteckrohres 301 für eine Stromschiene. Das Rechteckrohr 301 weist Trennwände 302 auf, die einen von dem Rechteckrohr 301 umschlossenen Innenraum in mehrere Einzelhohlräume 303 aufteilt. In den Einzelhohlräumen strömt Kühlmittel, um das Rechteckrohr 301 zu kühlen. Durch die Trennwände 302 ist die Kontaktfläche zwischen dem Kühlmittel und dem stromtragenden Material des Rechteckrohres im Vergleich zu einem Rechteckrohr mit einem einzelnen Innenraum größer.

Vorzugsweise wird gekühltes Kühlmittel in einem praktischen Anwendungsfall in einem Elektrofahrzeug von der Wärmesenke in die Stromschiene auf positivem Potential (HV+) einströmen und in der anderen Stromschiene auf Massepotential (HV-) wieder zu der Wärmesenke zurückgeführt. Grundsätzlich kann das Kühlmittel auch in der entgegengesetzten Richtung geführt sein. Die Erfindung ist jedenfalls nicht auf eine bestimmte Strömungsrichtung eingeschränkt. Werden Stromschienen mit Rechteckrohren eingesezt, dann können auch entgegengesetzte Strömungsrichtungen gleichzeitig vorliegen, wie nachfolgend erläutert wird.

In den Einzelhohlräumen 303 kann das Kühlmittel auch in unterschiedlichen Richtungen strömen, sodass bei einem Ladesystem mit zwei Stromschienen durch beide Stromschienen sowohl Kühlmittel, das in der Wärmesenke abgekühlt ist als auch Kühlmittel fließen, das die jeweils andere Stromschiene bereits durchflossen hat und gegenüber dem von der Wärmesenke kommenden Kühlmittel eine höhere Temperatur aufweist. In Figur 3 sind die unterschiedlichen Fließrichtungen durch Pfeile 304 angedeutet. Auf diese Weise wird erreicht das die beiden Stromschienen annähernd die gleiche Temperatur aufweisen. Im Unterschied dazu kann es bei einem Ladesystem, bei dem das Kühlmittel zunächst die eine Stromschiene durchströmt und anschließend die andere Stromschiene, bevor es wieder zu der Wärmesenke zurückkehrt, zu Temperaturunterschieden zwischen den Stromschienen kommen, was zur Folge haben kann, dass eine zulässige Grenztemperatur von der wärmeren Stromschiene schneller erreicht wird als bei einem Ladesystem, bei dem die Stromschienen auf einer gleichmäßigen Temperatur sind.

Grundsätzlich kann ein Anwender die Fließrichtung nach Belieben festlegen. In einer praktischen Ausführungsform hat es sich jedoch als zweckmäßig erwiesen, wenn in den inneren Einzelhohlräumen 303 das von der Wärmesenke stammende Kühlmittel fließt, während in den außenliegenden Einzelhohlräumen 303 das von der jeweils anderen Stromschiene heranströmende Kühlmittel fließt.

### Bezugszeichenliste

- 100: Stromschiene
- 101: Rechteckrohr
- 102a,b: Schmale Seite
- 103a,b: Breite Seite
- 104: Hohlraum

- 106: Enden
- 107: Kontaktstück
- 108: Gewindeloch
- 109: Schlauchnippel

- 111: Schlauch

- 200: Ladesystem
- 201: Ladedosen
- 202: Hochvoltbatterie
- 203: Kühlmittelauslass
- 204: Verbindungsstück

- 206: Kühlmittel Einlass
- 207a,b: Pfeile
- 208: Wärmetauscher
- 209: Kühlschlange
- 211: Ventilator

- 301: Rechteckrohr
- 302: Trennwand
- 303: Einzelhohlraum
- 304: Pfeil

## Patentansprüche

1. Elektrische Stromschiene, die als Hohlprofil (101,301) ausgebildet ist, dessen Hohlraum (104,303) von einem Kühlmittel durchströmt ist, wobei die Stromschiene (100a,b) einen Einlassanschluss und einen Auslassanschluss aufweist, wobei der Einlassanschluss so ausgebildet ist, um das Einströmen eines Kühlmittels in den Hohlraum (104,303) zu gestatten, wobei der Auslassanschluss so ausgebildet ist, um das Ausströmen des Kühlmittels aus dem Hohlraum zu ermöglichen, **dadurch gekennzeichnet, dass** mit den Enden (106) der Stromschiene bzw. des Hohlprofils Kontaktstücke (107) stoffschlüssig und elektrisch leitend verbunden sind und den Hohlraum (104,303) dicht verschließen.

2. Stromschiene nach Anspruch 1, **dadurch gekennzeichnet, dass** der Hohlraum (104) durch Trennwände (302) in eine Mehrzahl von Einzelhohlräumen (303) aufgeteilt ist.

3. Stromschiene nach Anspruch 2, **dadurch gekennzeichnet, dass** das Kühlmittel in einem ersten Einzelhohlraum (303) in einer ersten Strömungsrichtung strömt und dass das Kühlmittel in einem zweiten Einzelhohlraum (303) in einer zweiten Strömungsrichtung strömt, die der ersten Strömungsrichtung entgegengesetzt ist.

4. Ladesystem für einen batterieelektrischen Stromspeicher (202), wobei das Ladesystem einen mit einer Stromquelle verbindbaren Anschluss (201), eine Stromsenke (202), eine Stromschiene (100a,b) gemäß einem der vorstehenden Ansprüche, die die Stromquelle mit der Stromsenke elektrisch verbindet, sowie eine Wärmesenke (208,209) aufweist, die von dem Kühlmittel durchströmt ist.

5. Ladesystem nach Anspruch 4, wobei das Ladesystem zwei Stromschienen (100a,b) umfasst, die an jeweils einem Ende mittels eines Verbindungsstücks (204) strömungsmäßig und elektrisch voneinander isoliert miteinander verbunden sind, sodass das Kühlmittel aus der einen Stromschiene (100a) ausströmt und in die andere Stromschiene (100b) einströmt, wobei die anderen Enden der beiden Stromschienen einen Einlassanschluss bzw. einen Auslassanschluss aufweisen, die strömungsmäßig mit der Wärmesenke verbunden sind.

6. Ladesystem nach Anspruch 4 oder 5, wobei die Wärmesenke ein Wärmetauscher (208,209), ein Batteriespeicher (202), eine elektrische Maschine und oder eine Vorrichtung zur Regelung der Temperatur in einem Innenraum ist.

7. Ladesystem nach Anspruch 6, wobei der Wärmetauscher luftgekühlt ist.

8. Ladesystem nach einem der Ansprüche 5-7, wobei die zwei Stromschienen (100a,b) jeweils zwei oder mehr Einzelhohlräume (303) aufweisen, in denen das Kühlmittel in entgegengesetzten Richtungen strömt.
